# EUROPÄISCHE PATENTSCHRIFT

(11) **EP 2 244 094 B1**
(45) Veröffentlichungstag und Bekanntmachung des Hinweises auf die Patenterteilung: **09.11.2011**
(21) Anmeldenummer: 09005650.8
(22) Anmeldetag: 22.04.2009
(51) Int. Cl.: G01R 31/327

(54) **Vorrichtung und Verfahren zum Überprüfen eines Schaltvorgangs eines elektrischen Schalters**
Device and method for checking a switching process of an electrical switch
Dispositif et procédé de vérification d'un processus de commutation d'un commutateur électrique

(43) Veröffentlichungstag der Anmeldung: 27.10.2010
(60) Teilanmeldung: 11007174.3
(73) Patentinhaber: Omicron electronics GmbH, 6833 Klaus (AT)
(72) Erfinder: Klapper, Ulrich, 6830 Rankweil (AT); Steineke, Caspar, 10625 Berlin (DE)
(74) Vertreter: Banzer, Hans-Jörg

(56) Entgegenhaltungen:
- EP-A- 0 974 993
- EP-A- 1 006 537
- WO-A-01/50561
- WO-A-02/23571
- GB-A- 2 348 502
- US-A1- 2004 100 741
- US-A1- 2008 192 402
- US-B1- 6 354 161

## Beschreibung

Die vorliegende Erfindung betrifft Verfahren und Vorrichtungen zum Überprüfen eines Schaltvorgangs eines elektrischen Schalters, insbesondere Verfahren und Vorrichtungen zum Überprüfen von Öffnungs- und Schließvorgängen von elektrischen Höchst-, Hoch- und Mittelspannungsschaltern.

Elektrische Leistungsschalter und Lastschalter, wie z.B. Höchst-, Hoch- und Mittelspannungsschalter, müssen nach einer Neuinstallation, nach einem Umbau oder nach einer Revision geprüft werden, bevor sie wieder in Betrieb genommen werden dürfen. Eine wichtige Prüfung ist dabei die Aufnahme eines so genannten Weg-Zeitdiagramms, um insbesondere zu überprüfen, ob der Öffnungsvorgang oder Schließvorgang des Schalters schnell genug abläuft und ob am Ende eines Weges ein Abbremsen eines beweglichen Teils oder Schaltelements des Schalters in der gewünschten Art und Weise erfolgt.

Gemäß dem Stand der Technik wird dazu zwischen dem beweglichen Schaltelement des Schalters und einem festen Teil des Schalters ein Weg- oder ein Winkelaufnehmer angebracht. Mit Hilfe einer geeigneten Prüfvorrichtung.kann damit während des Schaltvorgangs der Weg oder der Winkel über der Zeit aufgezeichnet werden und mit Hilfe des so bestimmten Weg- oder Winkel-Zeitdiagramms können alle notwendigen weiteren Analysen durchgeführt werden. Das Anbringen des Weg- oder Winkelaufnehmers ist verhältnismäßig aufwändig, da die beweglichen Teile des elektrischen Schalters üblicherweise nicht leicht zugänglich sind und häufig sehr wenig Raum zum Anbringen der Aufnehmer vorhanden ist.

US 2008/192402 A1 und EP 1 006 537 A offenbaren ähnliche Vorrichtungen.

Aufgabe der vorliegenden Erfindung ist es daher, verbesserte Verfahren und Vorrichtungen zum Überprüfen eines Schaltvorgangs eines elektrischen Schalters bereitzustellen, welche insbesondere eine Montage vereinfachen und auch bei geringem Raumangebot in der Umgebung der beweglichen Teile des Schalters verwendbar und betreibbar sind.

Gemäß der vorliegenden Erfindung werden diese Aufgaben durch ein Verfahren zum Überprüfen eines Schaltvorgangs eines elektrischen Schalters nach Anspruch 1 und durch eine Vorrichtung zum Überprüfen eines Schaltvorgangs eines elektrischen Schalters nach Anspruch 6 gelöst. Die abhängigen Ansprüche definieren vorteilhafte und bevorzugte Ausführungsformen der Erfindung.

Gemäß der vorliegenden Erfindung wird ein Verfahren zum Überprüfen eines Schaltvorgangs eines elektrischen Schalters bereitgestellt. Das Verfahren umfasst ein Bestimmen einer Bewegung eines beweglichen Schaltelements des elektrischen Schalters während des Schaltvorgangs, indem eine Position einer optischen Markierung, welche an dem Schaltelement angebracht ist, optisch erfasst wird. Aus der erfassten Position der optischen Markierung wird die Bewegung des Schaltetements bestimmt. Das Anbringen der optischen Markierung an dem beweglichen Schaltelement des elektrischen Schalters erfordert nur einen minimalen Eingriff an dem Schalter und ist daher insbesondere bei sehr beengten Verhältnissen im Bereich des Schalters besonders geeignet. Das optische Erfassen der Position der optischen Markierung kann beispielsweise mit Hilfe einer elektronischen Bilderfassungsvorrichtung, wie z.B. einer Digitalkamera, erfolgen, welche mit Hilfe eines geeigneten Objektivs die Position der optischen Markierungen aus geeigneter Entfernung optisch erfassen kann. Weiterer Vorteil der Bestimmung der Bewegung des beweglichen Schaltelements mit Hilfe der optischen Markierungen ist, dass die optische Markierung die Bewegung des beweglichen Schaltelements nicht beeinflusst, da das Gewicht der optischen Markierung vernachlässigbar gering ist und keine mechanische Kopplung mit beispielsweise einem Weg- oder Winkelaufnehmer gemäß dem Stand der Technik erforderlich ist.

Das Bestimmen der Bewegung des beweglichen Schaltelements kann ein Bestimmen einer Geschwindigkeit des Schaltelements während des Schaltvorgangs und/oder ein Bestimmen einer Position des Schaltelements gegenüber einem feststehenden Teil des elektrischen Schalters umfassen. Mit Hilfe dieser Informationen ist eine genaue Analyse eines Bewegungsablaufs des beweglichen Schaltelements während des Schaltvorgangs möglich.

Gemäß einer Ausführungsform kann die optische Markierung zwei optische Markierungen in einem vorbestimmten Abstand umfassen. Die Bewegung des beweglichen Schaltelements wird in diesem Fall zusätzlich in Abhängigkeit des vorbestimmten Abstands bestimmt. Da der Abstand bekannt ist, können bei dieser Ausführungsform Perspektivenabhängigkeiten, welche durch unterschiedliche Entfernungen und Betrachtungswinkel zwischen der Bilderfassungsvorrichtung und den optischen Markierungen auftreten können, zuverlässig korrigiert werden.

Gemäß einer Ausführungsform werden die vorgenannten Verfahren zur Überprüfung eines Öffnungsvorgangs und/oder eines Schließvorgangs des elektrischen Schalters durchgeführt, indem ein Weg-Zeitdiagramm des beweglichen Schaltelements des elektrischen Schalters aufgenommen wird. Durch Umrechnen von Beschleunigungswerten in Geschwindigkeits- und Ortswerte bzw. durch Umrechnen der Positionen in Geschwindigkeits- und Beschleunigungswerte kann ein letztendlich interessierendes Weg-Zeitdiagramm für den Öffnungsvorgang und/oder den Schließvorgang des elektrischen Schalters auf einfache Art und Weise bestimmt werden.

Gemäß der vorliegenden Erfindung wird eine Vorrichtung zum Überprüfen eines Schaltvorgangs eines elektrischen Schalters bereitgestellt, welche eine an einem beweglichen Schaltelement des Schalters angebrachte optische Markierung, eine Bilderfassungsvorrichtung und eine Verarbeitungseinheit umfasst. Die Bilderfassungsvorrichtung ist derart ausgestaltet, dass sie eine Position der optischen Markierung an dem beweglichen Schaltelement erfassen kann. Die Verarbeitungseinheit ist mit der Bilderfassungsvorrichtung gekoppelt. Die Verarbeitungseinheit ist derart ausgestaltet, dass sie eine Bewegung des Schaltelements während des Schaltvorgangs in Abhängigkeit der erfassten Position der optischen Markierung bestimmen kann.

Die Bilderfassungsvorrichtung kann ferner zum optischen Erfassung einer dreidimensionalen Position der optischen Markierung ausgestaltet sein.

Gemäß einer Ausführungsform umfasst die Vorrichtung weiterhin eine Beleuchtungseinrichtung, welche zum Beleuchten der Markierung mit Licht eines vorbestimmten Wellenlängenbereichs ausgestaltet ist. Die Markierung ist in diesem Fall derart ausgestaltet, dass sie den vorbestimmten Wellenlängenbereich besonders gut reflektiert. Vorzugsweise liegt der vorbestimmte Wellenlängenbereich außerhalb des Bereichs von üblichem Tageslicht. Zusätzlich kann die Bilderfassungsvorrichtung ein Filter umfassen, welches nur Licht in dem vorbestimmten Wellenlängenbereich passieren lässt. Durch die Verwendung eines vorbestimmten Wellenlängenbereichs, vorzugsweise eines möglichst schmalen Wellenlängenbereichs, kann die Zuverlässigkeit der optischen Erfassung erheblich verbessert werden und darüber hinaus eine Bildverarbeitung, welche bei der Bewegungsbestimmung durchgeführt wird, erheblich vereinfacht werden.

Die Beleuchtungseinrichtung kann beispielsweise einen Laser mit einem vorbestimmten Wellenlängenbereich umfassen. Die Beleuchtungseinrichtung kann weiterhin eine Linienlinse umfassen, welche nur einen schmalen Bereich in der Bewegungsrichtung der an dem beweglichen Schaltelement angebrachten Markierung ausleuchtet.

Die Bilderfassungsvorrichtung und die Verarbeitungseinheit können in einem gemeinsamen integrierten Schaltkreis ausgebildet sein. Dadurch kann eine so genannte "On Chip"-Auswertung durchgeführt werden, wodurch eine Datenmenge, welche zwischen der Bilderfassungsvorrichtung und der Verarbeitungseinheit auszutauschen ist, nur lokal auf einem integrierten Schaltkreis übertragen wird. Dadurch ist eine Übertragung großer Datenmengen zwischen abgesetzten Einheiten nicht erforderlich, wodurch eine Erhöhung der Bildabtastungsfrequenz der Bilderfassungsvorrichtung möglich ist und die Positionserfassung erheblich genauer durchgeführt werden kann.

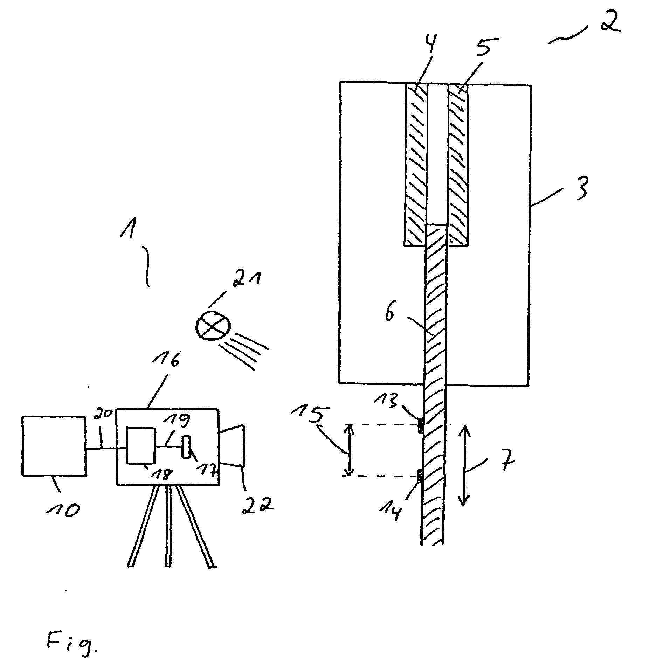

Die vorliegende Erfindung wird nachfolgend unter Bezugnahme auf die Zeichnung anhand bevorzugter Ausführungsformen erläutert werden.

Die einzige Figur zeigt eine schematische Darstellung einer Ausführungsform der vorliegenden Erfindung, welche zwei an einem beweglichen Schaltelement angebrachte Markierungen und eine Bilderfassungsvorrichtung verwendet.

Die Figur zeigt eine Ausführungsform einer Vorrichtung 1 zum Überprüfen eines Schaltvorgangs eines elektrischen Schalters 2. Der elektrische Schalter 2 umfasst eine Schaltkammer 3, in welcher zwei feststehende Kontakte 4, 5 sowie ein bewegliches Schaltelement 6 angeordnet sind. Das bewegliche Schaltelement 6 ist in einer Bewegungsrichtung 7 hin und her bewegbar.

Die gezeigte Vorrichtung 1 umfasst zwei optische Markierungen 13. 14, weiche in einem vorbestimmten Abstand 15 an dem beweglichen Schaltelement 6 angebracht sind. Die Vorrichtung 1 umfasst weiterhin eine Bilderfassungsvorrichtung 16 und eine Verarbeitungseinheit 10. Die Bilderfassungsvorrichtung 16 umfasst einen optischen Sensor 17, beispielsweise einen so genannten CCD-Sensor, und eine Bilderfassungseinheit 18. Der optische Sensor 17 ist über eine Verbindung 19 mit der Bilderfassungseinheit 18 gekoppelt. Die Bilderfassungseinheit 18 ist über eine Verbindung 20 mit der Verarbeitungseinheit 10 gekoppelt. Die Bilderfassungsvorrichtung 16 kann beispielsweise eine Digitalkamera mit einem Stativ umfassen. Die Vorrichtung 1 umfasst weiterhin eine Lichtquelle 21, welche beispielsweise als ein Scheinwerfer oder als ein Laser ausgebildet sein kann. Die Bilderfassungsvorrichtung 16 ist derart angeordnet, dass sie über ein Objektiv 22 der Bilderfassungsvorrichtung 16 ein Abbild des beweglichen Schaltelements 6 mit den daran angebrachten optischen Markierungen 13. 14 erfassen kann. Der optische Sensor 17 erfasst das Abbild der optischen Markierungen 13, 14 auf dem beweglichen Schaltelement 6 und überträgt die Bildinformationen an die Bilderfassungseinheit 18. Die Bilderfassungseinheit 18 stellt der Verarbeitungseinheit 10 entsprechende Digitalbilder mit einer vorbestimmten Bildwiederholfrequenz von beispielsweise 5000 Bildern pro Sekunde oder 10000 Bildern pro Sekunde zur Verfügung. Die Verarbeitungseinheit 10 analysiert die empfangenden digitalen Bilder und bestimmt die Positionen der optische Markierungen 13, 14. Da die Verarbeitungseinheit 10 eine Information über den vorbestimmten Abstand 15 zwischen den optischen Markierungen 13, 14 aufweist, ist es auf einfache Art und Weise möglich, aus einer Bildfolge von digitalen Bildern eine Bewegung der optischen Markierungen 13, 14 sowie deren Position und Geschwindigkeit zu bestimmen.

Durch eine geeignete Beleuchtung des beweglichen Schaltelements mit den daran angebrachten optischen Markierungen 13, 14 mit Hilfe einer Lichtquelle 21 mit einem schmalbandigen Wellenlängenspektrum und einem dazu passenden Filter vor der Bilderfassungsvorrichtung 16 kann der Rechenaufwand zur Bestimmen der Position der Markierungen 13, 14 erheblich reduziert werden. Weiterhin können die Markierungen 13, 14 eine vorbestimmte Form, z.B. rund, und eine vorbestimmte Farbe aufweisen. Dadurch kann die Bildverarbeitung in der Verarbeitungseinheit 10 weiter vereinfacht werden. Durch das Anbringen der optischen Markierungen 13, 14 mit vorbestimmtem Abstand 15 kann die Erfassung der optischen Markierungen 13, 14 durch die Bilderfassungsvorrichtung 16 unter verschiedenen Winkeln oder Perspektiven der Bilderfassungsvorrichtung 16 erfolgen. Zusätzlich werden an feststehenden Teilen des Schalters weitere Markierungen angebracht, um eine Bewegung des beweglichen Schaltelements bezogen auf die feststehenden Teile des Schalters zu bestimmen.

Als Lichtquelle 21 eignet sich vorzugsweise eine schmalbandige Lichtquelle, wie z.B. eine Laserlichtquelle. Darüber hinaus kann die Lichtquelle 21 eine Linienlinse umfassen, welche nur einen schmalen Bereich entlang der Bewegungsrichtung 7 im Bereich des beweglichen Schaltelements 6 ausleuchtet.

Die Lichtquelle 21 kann beispielsweise nur für die Zeit, in der der Schalter 2 betätigt wird, eingeschaltet werden. Das Ein- und Ausschalten der Lichtquelle 21 kann beispielsweise durch ein Signal erfolgen, welches den Schaltvorgang des Schalters 2 einleitet. Die Beleuchtung kann beispielsweise einige Sekunden länger leuchten als der Schaltvorgang dauert. Da die Lichtquelle 21 üblicherweise eine sehr begrenzte Lebensdauer aufweist, wird durch das Einschalten der Lichtquelle in Abhängigkeit des Schaltvorgangs die Lebensdauer der Lichtquelle erheblich verlängert.

Der optische Sensor 17, die Bilderfassungseinheit 18 und die Verarbeitungseinheit 10 können in einer integrierten Einheit auf einem Chip ausgebildet werden. Da bei einer Bildverarbeitung üblicherweise große Datenmengen übertragen werden, wird diese Datenübertragung auf den Chip begrenzt, wodurch eine erheblich schnellere Bildverarbeitung erreicht werden kann. Dadurch kann die Bildwiederholfrequenz erhöht werden und somit die Messung genauer und feingranularer durchgeführt werden. Eine Ausgabe der gesamten Bildinformation, beispielsweise um die korrekte Einstellung der Bilderfassungsvorrichtung 16 zu überprüfen, ist während der eigentlichen Messung des Schaltvorgangs nicht erforderlich, sondern es genügt, die Bewegungsinformationen der optischen Markierungen 13, 14 zu übertragen.

Schließlich kann die Auswertung der Bildinformationen ebenso wie die Lichtquelle in Abhängigkeit des Schaltvorgangs aktiviert werden. Die Bildverarbeitung wird aktiviert, sobald ein Ein- oder Ausschaltvorgang des Schalters 2 eingeleitet wird. Die Bildverarbeitung wird beendet, wenn der Schaltvorgang abgeschlossen ist, eine vorbestimmte Zeit vergangen ist oder die Verarbeitungseinheit 10 erkannt hat, dass das bewegliche Schaltelement 6 zur Ruhe gekommen ist.

## Patentansprüche

1. Verfahren zum Überprüfen eines Schaltvorgangs eines elektrischen Schalters, umfassend:
Bestimmen einer Bewegung eines beweglichen Schaltelements (6) des elektrischen Schalters (2) während des Schaltvorgangs durch optisches Erfassen einer Position einer an dem Schaltelement angebrachten optischen Markierung (13, 14),
**dadurch gekennzeichnet,**
**dass** zur Bestimmung der Bewegung des beweglichen Schaltelements (6) des elektrischen Schalters (2) die Position der an dem beweglichen Schaltelement (6) angebrachten optischen Markierung (13, 14) bezogen auf eine an einem feststehenden Teil (3-5) des elektrischen Schalters (2) angebrachte weitere optische Markierung optisch erfasst wird.

2. Verfahren nach Anspruch 1, **dadurch gekennzeichnet, dass** das Bestimmen der Bewegung ein Bestimmen einer Geschwindigkeit des Schaltelements (6) während des Schaltvorgangs umfasst.

3. Verfahren nach Anspruch 1 oder 2, **dadurch gekennzeichnet,**
- **dass** die optische Markierung (13, 14) zwei optische Signalpunkte in einem vorbestimmten Abstand (15) umfasst, und
- **dass** die Bewegung zusätzlich in Abhängigkeit des vorbestimmten Abstands (15) bestimmt wird.

4. Verfahren nach einem der Ansprüche 1-3, **dadurch gekennzeichnet, dass** die optische Markierung (13, 14) mittels einer Beleuchtungseinrichtung (21) beleuchtet wird, wobei die Beleuchtungseinrichtung (21) in Abhängigkeit des Schaltvorgangs des elektrischen Schalters eingeschaltet wird.

5. Verfahren nach einem der vorhergehenden Ansprüche, **dadurch gekennzeichnet, dass** das Verfahren zur Überprüfung eines Öffnungsvorgangs und/oder eines Schließvorgangs des elektrischen Schalters (2) durch Aufnahme eines Weg-Zeitdiagramms des beweglichen Schaltelements (6) des elektrischen Schalters (2) durchgeführt wird.

6. Vorrichtung zum Überprüfen eines Schaltvorgangs eines elektrischen Schalters, umfassend:
- eine an einem beweglichen Schaltelement (6) des Schalters (2) angebrachte optische Markierung (13, 14),
- eine Bilderfassungsvorrichtung (16), welche zum optischen Erfassen einer Position der optischen Markierung (13, 14) ausgestaltet ist, und
- eine Verarbeitungseinheit (10), welche mit der Bilderfassungsvorrichtung (16) gekoppelt ist und ausgestaltet ist, eine Bewegung des Schaltelements (6) während des Schaltvorgangs in Abhängigkeit der erfassten Position zu bestimmen, **dadurch gekennzeichnet,**
**dass** die Bilderfassungsvorrichtung (16) zum optischen Erfassen der Position der an dem beweglichen Schaltelement (6) des elektrischen Schalters (2) angebrachten optischen Markierung (13, 14) bezogen auf eine an einem feststehenden Teil (3-5) des elektrischen Schalters (2) angebrachte weitere optische Markierung ausgestaltet ist.

7. Vorrichtung nach Anspruch 6, **dadurch gekennzeichnet, dass** die Bilderfassungsvorrichtung (16) zum optischen Erfassen einer dreidimensionalen Position der optischen Markierung (13, 14) ausgestaltet ist.

8. Vorrichtung nach Anspruch 6 oder 7, ferner umfassend eine Beleuchtungseinrichtung (21), welche zum Beleuchten der Markierung (13, 14) mit Licht eines vorbestimmten Wellenlängenbereichs ausgestaltet ist, wobei die Markierung (13, 14) zum Reflektieren des vorbestimmten Wellenlängenbereichs ausgestaltet ist.

9. Vorrichtung nach Anspruch 8, **dadurch gekennzeichnet, dass** die Bilderfassungsvorrichtung (16) einen optischen Filter umfasst, welcher zum Filtern von Licht des vorbestimmten Wellenlängenbereichs ausgestaltet ist.

10. Vorrichtung nach Anspruch 8 oder 9, **dadurch gekennzeichnet, dass** die Beleuchtungseinrichtung (21) einen Laser und/oder eine Linienlinse umfasst.

11. Vorrichtung nach einem der Ansprüche 6-10, **dadurch gekennzeichnet, dass** die Bilderfassungsvorrichtung (16) und die Verarbeitungseinheit (10) in einem gemeinsamen integrierten Schaltkreis ausgebildet sind.

## Claims

1. Method for checking a switching process of an electrical switch, comprising:
determining a movement of a moveable switching element (6) of the electrical switch (2) during the switching process by optical detection of a position of an optical mark (13, 14) attached to the switching element,
**characterized in that**
for the determination of the movement of the moveable switching element (6) of the electrical switch (2), the position of the optical mark (13, 14) attached to the moveable switching element (6) is optically detected with reference to a further optical mark attached to a stationary part (3-5) of the electrical switch (2).

2. Method according to claim 1, **characterized in that** the determining of the movement comprises a determining of a velocity of the switching element (6) during the switching process.

3. Method according to claim 1 or 2, **characterized in that**
- the optical mark (13, 14) comprises two optical signal points having a predetermined distance (15), and
- the movement is in addition determined depending on the predetermined distance (15).

4. Method according to any one of claims 1-3, **characterized in that** the optical mark (13, 14) is illuminated by an illumination device (21), whereby the illumination device (21) is switched on depending on the switching process of the electrical switch.

5. Method according to any one of the preceding claims, **characterized in that** the method is carried out for checking an opening operation and/or a closing operation of the electrical switch (2) by determination of a distance-time diagram of the moveable switching element (6) of the electrical switch (2).

6. Apparatus for checking a switching process of an electrical switch, comprising:
- an optical mark (13, 14) attached to a moveable switching element (6) of the switch (2),
- an image capturing device (16) which is designed for optically capturing a position of the optical mark (13, 14), and
- a processing unit (10) which is coupled to the image capturing device (16) and is designed to determine a movement of the switching element (6) during the switching process depending on the detected position, **characterized in that**
the image capturing device (16) is designed for optically capturing the position of the optical mark (13, 14) attached to the moveable switching element (6) of the electrical switch (2) with reference to a further optical mark attached to a stationary part (3-5) of the electrical switch (2).

7. Apparatus according to claim 6, **characterized in that** the image capturing device (16) is designed for optically capturing a three-dimensional position of the optical mark (13, 14).

8. Apparatus according to claim 6 or 7, further comprising an illumination device (21) which is designed for the illumination of the mark (13, 14) with light of a predetermined wavelength range, whereby the mark (13, 14) is designed for reflecting the predetermined wavelength range.

9. Apparatus according to claim 8, **characterized in that** the image capturing device (16) comprises an optical filter which is designed to filter light of the predetermined wavelength range.

10. Apparatus according to claim 8 or 9, **characterized in that** the illumination device (21) comprises a laser and/or a line lens.

11. Apparatus according to any one of claims 6-10, **characterized in that** the image capturing device (16) and the processing unit (10) are formed in a common integrated circuit.

## Revendications

1. Procédé pour vérifier un processus de commutation d'un commutateur électrique, comprenant
détermination d'un mouvement d'un élément de commutation mobile (6) du commutateur électrique (2) pendant le processus de commutation grâce à la détection optique d'une position d'un marquage optique (13, 14) apposé sur l'élément de commutation,
**caractérisé en ce que**
pour la détermination du mouvement de l'élément de commutation mobile (6) du commutateur électrique (2), on détecte optiquement la position du marquage optique (13, 14) apposé sur l'élément de commutation mobile (6) par rapport à un autre marquage optique apposé sur une partie stationnaire (3-5) du commutateur électrique (2).

2. Procédé selon la revendication 1, **caractérisé en ce que** la détermination du mouvement comprend une détermination d'une vitesse de l'élément de commutation (6) pendant le processus de commutation.

3. Procédé selon la revendication 1 ou 2, **caractérisé en ce que**
- le marquage optique (13, 14) comprend deux points de signalisation optique à une distance (15) prédéfinie, et
- le mouvement étant défini de manière supplémentaire en fonction de la distance prédéfinie (15) .

4. Procédé selon l'une des revendications 1-3, **caractérisé en ce que** le marquage optique (13, 14) est éclairé à l'aide d'un dispositif d'éclairage (21), le dispositif d'éclairage (21) étant allumé en fonction du processus de commutation du commutateur électrique.

5. Procédé selon l'une des revendications précédentes, **caractérisé en ce que** le procédé pour vérifier un processus d'ouverture et/ou un processus de fermeture du commutateur électrique (2) est réalisé grâce à l'enregistrement d'un diagramme de temps-distance de l'élément de commutation mobile (6) du commutateur électrique (2).

6. Dispositif pour vérifier un processus de commutation d'un commutateur électrique, comprenant :
- un marquage optique (13, 14) apposé sur un élément de commutation mobile (6) du commutateur (2),
- un dispositif de détection d'image (16), lequel est conçu pour la détection optique d'une position du marquage optique (13, 14), et
- une unité de traitement (10), laquelle est couplée au dispositif de détection d'image (16) et est conçue pour déterminer un mouvement de l'élément de commutation (6) pendant le processus de commutation en fonction de la position détectée,
**caractérisé en ce que**,
le dispositif de détection d'image (16) est conçu pour la détection optique de la position du marquage optique (13, 14) apposé sur l'élément de commutation mobile (6) du commutateur électrique (2) compte tenu d'un autre marquage optique apposé sur une partie stationnaire (3-5) du commutateur électrique (2).

7. Dispositif selon la revendication 6, **caractérisé en ce que** le dispositif de détection d'image (16) est conçu pour la détection optique d'une position tridimensionnelle du marquage optique (13, 14).

8. Dispositif selon la revendication 6 ou 7, comprenant par ailleurs une unité d'éclairage (21), laquelle est conçu pour l'éclairage du marquage (13, 14) avec de la lumière d'une plage de longueurs d'ondes prédéfinie, le marquage (13, 14) étant conçu pour réfléchir la plage de longueurs d'ondes prédéfinie.

9. Dispositif selon la revendication 8, **caractérisé en ce que** le dispositif de détection d'image (16) comprend un filtre optique, lequel est conçu pour filtrer de la lumière de la plage de longueurs d'ondes prédéfinie.

10. Dispositif selon la revendication 8 ou 9, **caractérisé en ce que** le dispositif d'éclairage (21) comprend un laser et/ou une lentille de ligne.

11. Dispositif selon l'une des revendications 6-10, **caractérisé en ce que** le dispositif de détection d'image (16) et l'unité de traitement (10) sont réalisés dans un circuit intégré commun.
